# EUROPÄISCHE PATENTSCHRIFT

(11) **EP 2 488 386 B1**
(45) Veröffentlichungstag und Bekanntmachung des Hinweises auf die Patenterteilung: **14.04.2021**
(21) Anmeldenummer: 10770759.8
(22) Anmeldetag: 08.10.2010
(51) Int. Cl.: H02G 11/02, H02J 7/00, B60L 55/00, B60L 53/30, B60L 53/62, B60L 53/66

(54) **ELEKTRISCHE VERBINDUNGSVORRICHTUNG FÜR HYBRID- UND ELEKTROFAHRZEUGE SOWIE ZUGEHÖRIGES VERFAHREN ZUR AUFLADUNG**
ELECTRICAL CONNECTING DEVICE FOR HYBRID AND ELECTRIC VEHICLES AND ASSOCIATED METHOD FOR CHARGING
DISPOSITIF DE CONNEXION ÉLECTRIQUE POUR UN VÉHICULES HYBRIDES ET ÉLECTRIQUES AINSI QUE PROCÉDÉ DE CHARGE ASSOCIÉ

(30) Priorität: 13.10.2009 DE 102009045639
(43) Veröffentlichungstag der Anmeldung: 22.08.2012
(73) Patentinhaber: Robert Bosch GmbH, 70442 Stuttgart (DE)
(72) Erfinder: WUENSCH, Volkmar, 74199 Untergruppenbach (DE); NIEMANN, Holger, Shanghai 200120 (CN)
(86) Internationale Anmeldenummer: PCT/EP2010/065134
(87) Internationale Veröffentlichungsnummer: WO 2011/045248

(56) Entgegenhaltungen:
- DE-A1-102007 051 362
- US-A- 5 931 245
- US-A1- 2009 082 916
- US-B1- 6 281 663

## Beschreibung

### Technisches Gebiet

Die Erfindung betrifft eine Verbindungsvorrichtung sowie ein Verfahren zum Aufladen für Hybrid- und Elektrofahrzeuge, insbesondere zum Aufladen mittels elektrischer Leistung eines Versorgungsnetzes.

### Stand der Technik

Es ist bekannt, Hybrid- und Elektrofahrzeuge durch ein Verbindungskabel mittels eines Versorgungsnetzes aufzuladen. Die elektrischen Versorgungsnetze bieten eine Wechselspannung von 230 V (oder anderen standardisierten Spannungswerten wie 110 V), die sich jedoch zum einen auf Grund der Höhe der Spannung und zum anderen auf Grund ihrer Art, d. h. Wechselspannung, nicht unmittelbar zum Aufladen von Akkumulatoren von elektrisch betriebenen Fahrzeugen eignen. Akkumulatorvorrichtungen zur Traktion elektrisch betriebener Fahrzeuge erfordern eine Gleichspannung, wobei der Ladestrom durch die Höhe der Gleichspannung definiert ist.

Die US 6281663 B1 beschreibt eine elektrische Verbindungsvorrichtung nach der Präambel des unabhängigen Anspruchs 1 und ein Verfahren zum Aufladen einer Akkumulatorvorrichtung nach der Präambel des unabhängigen Anspruchs 6.

Es ist daher notwendig, zur Aufladung von Akkumulatorvorrichtungen mittels eines Wechselspannungsversorgungsnetzes einen Wechselstrom/Gleichstromwandler vorzusehen, der zum einen gleichrichtet und zum anderen eine Gleichspannung mit einstellbarer bzw. geeigneter Höhe bietet. Abhängig vom Lademechanismus kann die Gleichspannung auch vorab festgelegt sein, wobei sich jedoch bei üblichen Versorgungsnetzen von 230 V oder 110 V Effektivspannung durch bloße Gleichrichtung keine geeignete Spannungshöhe erreichen lässt.

Daher sind Wechselstrom/Gleichstromwandler notwendig, die gemäß dem Stand der Technik insbesondere an der Akkumulatorvorrichtung im Allgemeinen innerhalb des Fahrzeugs vorgesehen sind.

Somit besteht bei bekannten Aufladevorgängen die Verbindung zwischen Wechselstromverbundnetz und Fahrzeug aus einem einfachen Kabel, über das das Fahrzeug zum Aufladen der Akkumulatoren mit einem Wechselspannungsversorgungsnetz verbunden ist. Zum einen wird die Wandlung sowie die Anpassung an die geeignete Spannungshöhe innerhalb des Fahrzeugs vorgesehen, so dass bei unterschiedlichen Versorgungsnetzen ein Kompatibilitätsproblem besteht, insbesondere wenn Fahrzeuge in Länder mit unterschiedlichen Versorgungsspannungen exportiert werden. Zum anderen müssen die Wechselstrom/Gleichstromwandler spezifisch für die Akkumulatorvorrichtung und spezifisch für die Spannung ausgelegt werden, die ein Verbundnetz, d.h. die elektrische Versorgung, in einem Gebiet vorsieht, in dem das Fahrzeug betrieben wird.

Es ist daher eine Aufgabe der Erfindung, eine vereinfachende elektrische Verbindungsvorrichtung und ein vereinfachendes Verfahren zum Aufladen einer Ackumulatorvorrichtung vorzusehen.

### Offenbarung der Erfindung

Erfindungsgemäß wird diese Aufgabe bei der elektrischen Verbindungsvorrichtung durch die Merkmalskombination gemäß unabhängigem Anspruch 1 und bei dem Verfahren zum Aufladen einer Akkumulatorvorrichtung durch die Merkmalskombination gemäß unabhängigem Anspruch 6 gelöst.

Das der Erfindung zu Grunde liegende Konzept ist es, den Wechselstrom/Gleichstromwandler nicht gemäß dem Stand der Technik an der Akkumulatorvorrichtung bzw. in dem Fahrzeug vorzusehen, in dem sich die Akkumulatorvorrichtung befindet, sondern die notwendige Umwandlung und somit auch den Wandler selbst außerhalb des Fahrzeugs vorzusehen, d. h. innerhalb einer elektrischen Verbindungsvorrichtung, die zur Verbindung zwischen fest stehendem Netzanschluss eines Niederspannungsverbundnetzes und Ladeanschluss des Fahrzeugs eingereichtet ist.

Die erfindungsgemäße elektrische Verbindungsvorrichtung umfasst daher einen Versorgungsanschluss, mit dem die Verbindungsvorrichtung an den Netzanschluss angeschlossen werden kann. In gleicher Weise umfasst die erfindungsgemäße elektrische Verbindungsvorrichtung einen Abgabeanschluss, der mit dem Ladeanschluss verbunden werden kann. Sowohl Netzanschluss als auch Ladeanschluss des Fahrzeugs sind nicht Teil der elektrischen Verbindungsvorrichtung, sondern stellen für den Versorgungsanschluss bzw. für den Abgabeanschluss der Verbindungsvorrichtung komplementäre Verbindungselemente dar. Während des Aufladens ist somit der Versorgungsanschluss mittels einer (arretierbaren und lösbaren) Steckverbindung mit dem Netzanschluss verbunden, beispielsweise über einen üblichen Netzstecker, und der Abgabeanschluss ist über eine (arretierbare und lösbare) Steckverbindung mit dem Ladeanschluss des Fahrzeugs verbunden, wobei diese Verbindungen mit dem Fahrzeug bzw. Verbundnetz auftrennbar sind. Zwischen Versorgungsanschluss und Abgabeanschluss der Verbindungsvorrichtung ist der Wechselstrom/Gleichstromwandler vorgesehen, so dass der Eingang des Wandlers mit dem Versorgungsanschluss verbunden ist und der Ausgang des Wandlers mit dem Abgabeanschluss verbunden ist. Ferner umfasst die elektrische Verbindungsvorrichtung mindestens ein Kabel, wobei das mindestens eine Kabel zwischen Versorgungsanschluss und Wandler vorgesehen sein kann, wobei das mindestens eine Kabel ein weiteres Kabel umfassen kann, das den Wandler mit dem Abgabeanschluss verbindet. Erfindungsgemäß umfasst der elektrische Verbindungsanschluss zur Aufnahme des Kabels eine Kabeltrommel, mit der das mindestens eine Kabel (vorzugsweise sämtliche Kabelstücke des mindestens einen Kabels) aufgerollt werden kann. In dieser Kabeltrommel oder an diese befestigt befindet sich der Wechselstrom/Gleichstromwandler, um die von diesem abgegebene Gleichspannung einstellen zu können oder gemäß einem gewünschten Lademodus vorzusehen. In gleicher Weise ist der Wandler eingerichtet, mit unterschiedlichen Wechselspannungen und/oder unterschiedlichen Frequenzen zu arbeiten, ohne dass sich hierdurch die Ausgangsspannung (bei gleicher Konfiguration) ändert. Erfindungsgemäß ist der Wandler eingerichtet, an ein 110-Vol-Netz und an ein 230-Volt-Netz mit Wechselspannung einer Frequenz von 50 oder 60 Hz angeschlossen zu werden und aus diesem eine einzustellende Ausgangsgleichspannung zu erzeugen, die am Abgabeanschluss abgegeben wird.

Die erfindungsgemäße Verbindungsvorrichtung ist mit einem weiteren Sicherungsmechanismus vorgesehen, der zunächst erfasst, ob der Abgabeanschluss noch am Ladeanschluss ansteckt bzw. ob sich noch zumindest ein Teil des Kabels außerhalb der Kabeltrommel befindet, um daraus zu schließen, dass das Fahrzeug zumindest mechanisch mit der Verbindungsvorrichtung verbunden ist. Falls so erfasst wird, dass die Verbindungsvorrichtung noch nicht von dem Fahrzeug gelöst ist, dann hindert über eine Daten- bzw. eine Steuerschnittstelle die elektrische Verbindungsvorrichtung das Fahrzeug daran, in einen Fahrmodus überzugehen. Dies erfolgt durch einen Befehl der elektrischen Verbindungsvorrichtung, der über die noch bestehende Verbindung zwischen Abgabeanschluss und Ladeanschluss an das Fahrzeug übermittelt wird, wobei eine Fahrbetriebssteuerung des Fahrzeugs dadurch die Information erhält, dass ein Fahrmodus zu sperren ist.

Ferner kann durch die Verbindungsvorrichtung ein Datenaustausch vorgesehen sein, bei dem der Ladeanschluss bzw. das Fahrzeug selbst über dessen Steuerung Daten an die elektrische Verbindungsvorrichtung bzw. an den Wandler übermittelt, um den Wandler gemäß der vom Fahrzeug gewünschten Ladespannung aufzuladen. In gleicher Weise kann von der Fahrzeugsteuerung bzw. von einer Ladekontrolle des Fahrzeugs ein Befehl über den Ladeanschluss und den Abgabeanschluss und somit über die dadurch vorgesehene Datenschnittstelle an den Wandler ein Parameter oder ein Steuerbefehl übertragen werden, der einen gewünschten Lademodus angibt. Ein derartiger Lademodus kann beispielsweise ein Aufladen oder eine Erhaltungsladung wiedergeben, wobei der Wandler gemäß diesem Befehl eingestellt wird, um einen entsprechenden Strom und/oder eine entsprechende Spannung an den Abgabeanschluss abzugeben. Dadurch wird die elektrische Verbindungsvorrichtung universell einsetzbar, da sie nicht auf einen spezifischen Akkumulatortyp festgelegt ist, sondern von dem entsprechenden Fahrzeug frei konfigurierbar ist. Dies erlaubt den Einsatz der erfindungsgemäßen elektrischen Verbindungsvorrichtung für eine Vielzahl von Fahrzeugmodellen.

In gleicher Weise eignet sich ein und dieselbe elektrische Verbindungsvorrichtung für eine Vielzahl von Lademodi, soweit diese über die Datenverbindung an die Verbindungsvorrichtung übermittelt werden können. In einer besonders einfachen Ausführung wird über ein normiertes Datenübertragungsprotokoll ein Spannungswert an die Verbindungsvorrichtung abgegeben, der als Sollwert für den Wandler gilt. Insbesondere durch wiederholte Übertragung derartiger Spannungswerte lässt sich jedes beliebige Spannungsprofil bzw. jeder beliebige Ladungsmodus von der Steuerung des Fahrzeugs aus einstellen, wobei der Wandler der erfindungsgemäßen Verbindungsvorrichtung dadurch jede gewünschte Spannung über den Abgabeanschluss an den Akkumulator des Fahrzeugs abgeben kann. Hierbei ist lediglich eine normierte Datenschnittstelle notwendig, die vorzugsweise kabelgebunden ist (beispielsweise in der Art eines USB-Anschlusses) oder als eine Verbindung über eine Funkschnittstelle oder mittels Nahfeldinduktion oder über eine Infrarotschnittstelle vorgesehen werden kann. Bevorzugt wird jedoch eine kabelgestützte Datenschnittstelle verwendet, die eine Steckverbindung vorsieht, welche mechanisch innerhalb des Abgabeanschlusses (oder komplementär: innerhalb des Ladeanschlusses) vorgesehen ist, parallel zu einem Leistungsanschluss, über den die Ladespannung bzw. der Ladestrom an dem Abgabeanschluss an das Fahrzeug übertragen wird. Die Datenschnittstelle bzw. deren körperliche Ausprägung (beispielsweise als Steckverbindung) innerhalb des Abgabeanschlusses ist vorzugsweise mechanisch fest verbunden mit den Verbindungskomponenten des Abgabeanschlusses, über die ein Ladestrom vom Wandler über den Abgabeanschluss an das Fahrzeug übertragen wird, wenn die Verbindungsvorrichtung an dem Fahrzeug angeschlossen ist.

Die erfindungsgemäße elektrische Verbindungsvorrichtung umfasst daher einen Abgabeanschluss, der eingerichtet ist, mit einem Ladeanschluss eine Akkumulatorvorrichtung eines mit Strom betriebenen Fahrzeugs abtrennbar verbunden zu werden. Die elektrische Verbindungsvorrichtung umfasst ferner einen Versorgungsanschluss, der eingerichtet ist, mit einem Netzanschluss eines Wechselstrom-Niederspannungsverbundnetzes abtrennbar verbunden zu werden. Der Abgabeanschluss der elektrischen Verbindungsvorrichtung und der Ladeanschluss eines damit zu verbindenden Fahrzeugs sind somit komplementäre Verbindungselemente. In gleicher Weise sind der Versorgungsanschluss der elektrischen Verbindungsvorrichtung und der Netzanschluss des Wechselstrom-Niederspannungsverbundnetzes komplementär zueinander. Der Netzanschluss eines Wechselstrom-Niederspannungsverbundnetzes wird üblicherweise vorgesehen durch einen üblichen Wechselstromversorgungsanschluss eines 230-Volt- oder 110-Voltstromanschlusses, zu dem der Versorgungsanschluss komplementär ist. Beispielsweise hat der Netzanschluss die Form einer üblichen 230-Volt-Wechselstromsteckdose und der Versorgungsanschluss ist daher gemäß einem üblichen Netzstecker ausgebildet. Vorzugsweise unterscheidet sich der Abgabeanschluss von dem Versorgungsanschluss, um Vertauschungen zu vermeiden.

Die erfindungsgemäße elektrische Verbindungsvorrichtung umfasst einen Wechselstrom/Gleichstromwandler, der auch als AC/DC-Wandler bezeichnet wird. Der Wandler weist vorzugsweise eine Nennleistung auf, mit der sich die gewünschten Ladeströme realisieren lassen, beispielsweise eine Nennleistung von mindestens 0,5 kW, 1 kW, 2 kW, oder 5 kW oder 10 kW. Der Eingang des Wechselstrom/Gleichstromwandlers ist vorzugsweise zweiphasig ausgestaltet, kann jedoch auch für einen dreiphasigen Anschluss vorgesehen sein. Im Falle eines dreiphasigen Anschlusses ist der Versorgungsanschluss der erfindungsgemäßen Verbindungsvorrichtung als Drehstromanschluss ausgelegt und mit einer üblichen Drehstrombuchse verbindbar ausgestaltet. Der Wandler der erfindungsgemäßen Verbindungsvorrichtung ist eingerichtet, Wechselspannung des Versorgungsanschlusses in eine für die Akkumulatorvorrichtung geeignete elektrische Gleichspannung umzuwandeln. Hierzu ist der Wandler konfigurierbar bzw. einstellbar, so dass die Ausgangsspannung gewählt werden kann.

Der Abgabeanschluss weist vorzugsweise ein zweipoliges Steckverbindungselement auf, mit dem die Verbindungsvorrichtung an den Ladeanschluss eines Fahrzeugs angeschlossen werden kann. Hierzu sind zahlreiche Kabel mit ausreichendem Querschnitt geeignet, die eine Stromübertragung von mindestens 5A, 10 A, 20 A oder 50 A ermöglichen. Der Abgabeanschluss ist daher geeignet, an einen Ladeanschluss einer Akkumulatorvorrichtung eines Fahrzeugs angeschlossen zu werden, wobei das Fahrzeug ein Hybrid- oder Elektro-Personenkraftfahrzeug sein kann und die Akkumulatorvorrichtung in ihrer Kapazität und Leistung für die Verwendung als Traktionsenergiespeicher innerhalb eines Hybrid- oder Elektro- Personenkraftfahrzeugs geeignet ist. Insbesondere ist der Abgabeanschluss eingerichtet, mit einem Ladeanschluss der Akkumulatorvorrichtung verbunden zu werden, die als Traktionsenergiespeicher für ein Hybrid- oder Elektro-Personenkraftfahrzeug dient und somit eine hohe Kapazität aufweist, insbesondere höher als die Kapazitäten von Akkumulatoren eines verbrennungsmotorgetriebenen Kraftfahrzeugs.

Erfindungsgemäß ist der Wandler eingerichtet, eine Gleichspannung einstellbarer Höhe abzugeben. Die einstellbare Höhe kann vorgesehen sein durch einen Speicher innerhalb der elektrischen Verbindungsvorrichtung oder kann übermittelt werden über einen Eingang der elektrischen Verbindungsvorrichtung. Somit umfasst der Wechselstrom/Gleichstromwandler einen Speicher, in dem ein Wert abgelegt ist, der die Höhe der Spannung als Sollwert definiert. Alternativ oder in Kombination hiermit kann der Wechselstrom/Gleichstromwandler (oder die Verbindungsvorrichtung) einen Eingang umfassen, an den die Höhe der Spannung als Sollwert für den Wandler eingegeben werden kann. Alternativ oder in Kombination hiermit kann der Wandler oder die Verbindungsvorrichtung einen Schalter umfassen, dessen Stellung die Höhe der Spannung als Sollwert definiert. Schließlich kann alternativ oder in Kombination hiermit die Verbindungsvorrichtung oder der Wandler ein Potentiometer umfassen, dessen Stellung die Höhe der Spannung als Sollwert definiert. Dadurch lässt sich die Spannung als Ausgangsspannung des Wandlers abhängig von dem anzuschließenden Fahrzeug einstellen.

Erfindungsgemäß umfasst die elektrische Verbindungsvorrichtung ferner eine Kabeltrommel zur Aufnahme des mindestens einen Kabels der elektrischen Verbindungsvorrichtung. Die Verbindungsvorrichtung umfasst somit ferner mindestens ein Kabel, um den Wandler an den Versorgungsanschluss, an den Abgabeanschluss oder an beide anzuschließen. Die Kabeltrommel bietet ausreichend inneren Raum zur Aufnahme des Kabels und umfasst ferner einen Aufrollmechanismus, um das Kabel im Wesentlichen vollständig in die Kabeltrommel einzuziehen. Unter "im Wesentlichen vollständiger Aufnahme des Kabels" ist zu verstehen, dass die Kabeltrommel bzw. deren innerer Raum das Verbindungskabel größtenteils umfasst und nur kurze Kabelstücke (wenn gegeben) und gegebenenfalls der Versorgungsanschluss bzw. der Abgabeanschluss vollständig oder teilweise außerhalb der Kabeltrommel vorgesehen sind und das mindestens eine Kabel im Wesentlichen vollständig in der Kabeltrommel aufgenommen ist. Unter "vollständiger Aufnahme" wird daher auch ein Zustand verstanden, bei dem der Versorgungsanschluss bzw. der Abgabeanschluss vollständig oder teilweise aus der Kabeltrommel herausragen. Gleiches gilt für kurze Abschnitte des Kabels, das sich an den Versorgungsanschluss bzw. an den Abgabeanschluss direkt anschließt. Das mindestens eine Kabel verbindet den Abgabeanschluss über den Wandler mit dem Versorgungsanschluss. Hierbei kann das mindestens eine Kabel zwei Teilstücke umfassen, die zwischen Wandler und Abgabeanschluss bzw. zwischen Wandler und Versorgungsanschluss vorgesehen sind. Ferner kann jedoch auch nur ein einzelnes Kabel vorgesehen sein, das den Wandler mit dem Versorgungsanschluss verbindet oder das den Wandler mit dem Abgabeanschluss verbindet, wobei ein zusätzliches externes Kabel zur Verbindung mit dem Netzanschluss bzw. mit dem Ladeanschluss notwendig ist.

Erfindungsgemäß ist die elektrische Verbindungsvorrichtung mit einem Sicherungsmechanismus vorgesehen, der ein daran angeschlossenes Fahrzeug am Wegfahren hindert. Eine derartige Verbindungsvorrichtung umfasst ferner einen Sensor, der in dem Abgabeanschluss oder an dem Wechselstrom/Gleichstromwandler vorgesehen ist. Der Sensor ist eingerichtet, elektronisch oder mechanisch zu ermitteln, ob der Abgabeanschluss in einem daran anschließbaren Ladeanschluss eingesteckt ist. Der Sensor ist somit in der Lage, den Verbindungszustand zwischen Abgabeanschluss und Ladeanschluss zu erfassen, so dass der Sensor Daten vorsieht, die für den Sicherheitsmechanismus verwendet werden. Erfindungsgemäß ist der Sensor eingerichtet, zu ermitteln, ob sich die elektrische Verbindungsvorrichtung in einem im Wesentlichen vollständig eingerollten Zustand befindet. Der Sensor ist daher in der Lage, zu erfassen, ob das mindestens eine Kabel vollständig in der Kabeltrommel aufgenommen ist. Falls dies der Fall ist, kann davon ausgegangen werden, dass keine Verbindung zwischen Ladeanschluss und Abgabeanschluss besteht. Diese Ausführungsform betrifft insbesondere eine erfindungsgemäße Verbindungsvorrichtung, bei der zwischen Wandler und Abgabeanschluss ein Kabelstück des mindestens einen Kabels vorgesehen ist. Der Sensor kann beispielsweise mittels eines Schalters den eingesteckten Zustand erfassen oder kann erfassen, ob die Kabeltrommel weit aufgerollt ist. Alternativ können optische Erfassungsmechanismen oder Ähnliches verwendet werden. Gemäß einer weiteren Ausführungsform ist der Sensor durch mindestens einen elektrischen Kontakt vorgesehen, der am Abgabeanschluss vorgesehen ist und der durch ein Verbindungselement im Ladeanschluss verbunden ist, wenn der Abgabeanschluss im Ladeanschluss vorgesehen ist, und der nicht verbunden ist, wenn sich der Abgabeanschluss außerhalb des Ladeanschlusses befindet.

Diese Sensordaten werden an eine Steuerung weitergeleitet, um auf Grund der Sensordaten ein Fahrzeug zu arretieren (d. h. einen aktiven Fahrzustand zu blockieren) und ein Fahrzeug zum Fahren freizugeben, wenn ermittelt wird, dass der Abgabeanschluss nicht mit dem Ladeanschluss verbunden ist. Daher weist die erfindungsgemäße Verbindungsvorrichtung, deren Abgabeanschluss, eine Datenschnittstelle auf, die an eine Datenschnittstelle eines Ladeanschlusses eines Fahrzeugs angeschlossen werden kann. Die Datenschnittstelle des Abgabeanschlusses ist eingerichtet, Steuerdaten und Sensordaten an die dazu komplementäre Datenschnittstelle des Ladeanschlusses abzugeben. Die Sensordaten geben einen Steckzustand des Abgabeanschlusses oder andere Zustandsdaten der Verbindungsvorrichtung wieder. Insbesondere geben die Sensordaten wieder, ob der Abgabeanschluss noch mit dem Ladeanschluss verbunden ist oder nicht. Auf Grund der Sensordaten erzeugt die erfindungsgemäße Verbindungsvorrichtung, vorzugsweise der Wandler, Steuerdaten, um diese über die Datenschnittstelle des Abgabeanschluss an das Fahrzeug bzw. an eine Fahrzeugsteuerung des Fahrzeugs abzugeben. Die Steuerdaten umfassen daher einen Fahrbetrieb-Steuerbefehl, der die Fahrzeugsteuerung dazu veranlasst, einen Startwunsch zu ignorieren bzw. sämtliche möglichen Übergänge in einen Fahrzustand des Fahrzeugs zu unterdrücken. Die Steuerdaten, insbesondere der Fahrbetriebbefehl, werden von der elektrischen Verbindungsvorrichtung erzeugt, die hierzu eingerichtet ist, wobei auch Sensordaten von der elektrischen Verbindungsvorrichtung erzeugt und über den Abgabeanschluss abgegeben werden. Ferner ist die Datenschnittstelle des Abgabeanschluss eingerichtet, Daten in die umgekehrte Richtung zu übermitteln. Steuerdaten, die von der Verbindungsvorrichtung über den Abgabeanschluss zum Fahrzeug hin übertragen werden, umfassen insbesondere den Fahrbetrieb-Steuerbefehl. Steuerdaten, die in die entgegengesetzte Richtung übertragen werden, d. h. zur Verbindungsvorrichtung hin (und vom Fahrzeug ausgehend), umfassen einen Aufladebefehl oder einen Erhaltungsladungsbefehl. Gemäß diesem Befehl wird entweder der Wandler zur Abgabe eines Aufladestroms veranlasst oder zur Abgabe eines Erhaltungsladungsstroms veranlasst. Alternativ können anstatt des Befehls auch Steuerdaten übertragen werden, die einen Spannungssollwert oder einen Stromsollwert vorgeben, demgemäß der Wandler betrieben wird. Ferner können Sensordaten, die von dem Abgabeanschluss zur Verbindungsvorrichtung übertragen werden, ein Soll-Ladeverhalten oder andere Ladeparameter wiedergeben, insbesondere Betriebszustandsdaten des Fahrzeugs, woraus der Wandler auf einen geeigneten Modus schließen kann.

Demnach ist der Abgabeanschluss der erfindungsgemäßen Verbindungsvorrichtung mit einem Stromübertragungselement, beispielsweise in Form von Starkstromsteckern, ausgestattet sowie mit einer vorzugsweise kabelgebunden ausgeführten Steckverbindung, die die Datenschnittstelle des Abgabeanschlusses vorsieht. Die Datenschnittstelle ist vorzugsweise eine serielle Datenschnittstelle gemäß einem normierten Protokoll. Daher müssen Fahrzeuge lediglich das Datenübertragungsprotokoll beherrschen, um gemäß fahrzeuginterner Vorgaben von der erfindungsgemäßen Verbindungsvorrichtung geladen zu werden.

In einer weiteren Ausführungsform ist die Datenschnittstelle als Funkverbindung vorgesehen, wobei beispielsweise der Wandler eine entsprechende Sende- /Empfangsvorrichtung aufweist, zusammen mit einer Steuerung, die zur Stromwandlung vorgesehene Komponenten gemäß den mittels Funkschnittstelle empfangenen Daten steuert.

Die Erfindung wird ferner vorgesehen durch ein Verfahren zum Aufladen einer Akkumulatorvorrichtung eines mit Strom betriebenen Fahrzeugs. Das Verfahren basiert auf der Verwendung der elektrischen Verbindungsvorrichtung, so dass zumindest Aufladen mittels der oben beschriebenen elektrischen Verbindungsvorrichtung vorgesehen wird. Das Verfahren umfasst Wandeln einer Wechselspannung eines Wechselstrom-Niederspannungsverbundnetzes in eine Gleichspannung, die zum Aufladen einer Akkumulatorvorrichtung geeignet ist. Alternativ kann die Wechselspannung (von dem Wandler der Verbindungseinrichtung) in eine Gleichspannung umgewandelt werden, die zum Erhaltungsladen der Akkumulatorvorrichtung geeignet ist, d.h. zum Vorsehen einer Gleichspannung, aus der, zusammen mit dem Akkumulator, ein Ladestrom resultiert, der im Wesentlichen der Selbstentladung und dem Standby-Stromverbrauch des Fahrzeugs entspricht. Die Gleichspannung des Wandlers wird über den Abgabeanschluss der erfindungsgemäßen elektrischen Verbindungsvorrichtung einem Ladeanschluss des Fahrzeugs zugeführt. Der verwendete Wandler befindet sich jedoch nicht wie im Stand der Technik innerhalb des Fahrzeugs, sondern außerhalb des Fahrzeugs in der elektrischen Verbindungsvorrichtung, die die Verbindung zwischen Fahrzeug und Netzanschluss vorsieht. Die elektrische Verbindungsvorrichtung, insbesondere der Wechselstrom/Gleichstromwandler ist daher während des Ladens außerhalb des Fahrzeugs vorgesehen. Dadurch, dass der Wandler außerhalb des Fahrzeugs vorgesehen ist, ist dieser in der Lage, den Verbindungszustand zwischen Abgabeanschluss und Ladeanschluss zu erfassen und dementsprechend zu reagieren (beispielsweise durch Ansteuern einer Fahrzeugsteuerung, um einen Fahrmodus zu blockieren) und ist ferner in der Lage, für verschiedene Fahrzeuge verwendet werden zu können. Insbesondere sieht die Verbindungsvorrichtung eine trennbare Schnittstelle vor, mit der der Wandler von dem Akkumulator abgetrennt werden kann, um den Wandler für andere Fahrzeuge verwenden zu können und um den Wandler außerhalb des Fahrzeugs zu diesem Zweck vorzusehen. Das Verfahren umfasst daher das Verbinden der Verbindungsvorrichtung mit dem Fahrzeug über eine abtrennbare Verbindung. Diese wird wie oben beschrieben vorgesehen durch einen Abgabeanschluss der Verbindungsvorrichtung und einen Ladeanschluss des Fahrzeugs, die zueinander komplementär sind und eine trennbare Steckverbindung vorsehen.

Das erfindungsgemäße Verfahren umfasst vorzugsweise ferner den oben beschriebenen Sicherungsmechanismus, der darauf basiert, dass die erfindungsgemäße Verbindungsvorrichtung erfasst, ob der Abgabeanschluss noch mit dem Ladeanschluss verbunden ist oder nicht, und dementsprechend durch Erzeugung von entsprechenden Steuerungssignalen oder -befehlen das Fahrzeug am Starten bzw. Fahren hindert. Erfindungsgemäß wird zur Erfassung des Steckzustands zwischen Abgabeanschluss und Ladeanschluss (die zueinander komplementär sind) ein Ausrollzustand eines Kabels der elektrischen Verbindungsvorrichtung erfasst. Der Ausrollzustand bezeichnet die Lage des mindestens einen Kabels zum inneren Raum der Kabeltrommel, wobei davon ausgegangen wird, dass sich das Kabel und der Abgabeanschluss im Wesentlichen vollständig innerhalb der Kabeltrommel befinden, wenn der Abgabeanschluss und ein Großteil des Kabels innerhalb der Kabeltrommel vorgesehen sind. In diesem Fall wird davon ausgegangen, dass die erfindungsgemäße Verbindungsvorrichtung nicht ausgerollt ist, sondern der Abgabeanschluss getrennt von dem Ladeanschluss vorliegt, so dass ein Startvorgang oder Fahrbetrieb des Fahrzeugs nicht unterbunden wird. Demgemäß wird der Fahrbetrieb des Fahrzeugs gesperrt, wenn durch den Schritt des Erfassens ermittelt wird, dass die elektrische Verbindungsvorrichtung mit einem Ladeanschluss des Fahrzeugs verbunden ist, d.h. dass der Abgabeanschluss mit dem Ladeanschluss verbunden ist. Erfindungsgemäß wird durch den Schritt des Erfassens ermittelt, dass ein Kabel der elektrischen Verbindungsvorrichtung sich nicht in einem im Wesentlichen vollständig aufgerollten Zustand befindet, wodurch ebenso der Fahrbetrieb des Fahrzeugs gesperrt wird.

Gemäß dem erfindungsgemäßen Verfahrens ist die erfindungsgemäße elektrische Verbindungseinrichtung ein aktiver Bestandteil des Sperrmechanismus und erzeugt und übermittelt einen Sperrbefehl an das Fahrzeug oder eine Fahrsteuerung des Fahrzeugs. Der Sperrbefehl wird somit nicht nur von der elektrischen Verbindungsvorrichtung übermittelt, sondern auch von dieser erzeugt, vorzugsweise von einer Steuerung des Wandlers.

Hierbei wird der Sperrbefehl übermittelt über eine Datenschnittstelle, die von der elektrischen Verbindungsvorrichtung vorgesehen wird. Die Datenschnittstelle wird insbesondere gebildet durch die zueinander komplementären Datenschnittstellen des Abgabeanschlusses und des Ladeanschlusses. Vorzugsweise sind Abgabeanschluss und dessen Datenschnittstelle miteinander mechanisch verbunden, wodurch beim Entfernen bzw. beim Einstecken des Abgabeanschlusses durch die mechanische Verbindung zwischen diesem Abgabeanschluss und dessen Datenschnittstelle diese von der Datenschnittstelle des Ladeanschlusses getrennt bzw. mit dieser verbunden wird. Über die mechanische Verbindung wird das Entfernen und Einstecken des Abgabeanschlusses in den Ladeanschluss die Verbindung zur elektrischen Energieübertragung mit der Verbindung zur Datenübertragung (d.h. mit der Datenschnittstelle) synchronisiert, so dass beide gleichzeitig entfernt bzw. eingesteckt werden.

Ferner kann nicht nur die mechanische Verbindung zwischen Abgabeanschluss und Ladeanschluss durch elektrische oder mechanische Sensoren erfasst werden, sondern die Verbindung zwischen Abgabeanschluss und Ladeanschluss kann auch elektrisch überwacht werden, indem die Verbindungsvorrichtung, und insbesondere der Wandler, eine elektrische Verbindung durch Erfassung eines Stromflusses überprüfen und dementsprechend einen Kontakt sensieren. Bei einem fehlenden Kontakt zwischen Abgabeanschluss und Ladeanschluss kann kein Strom durch die Verbindungsvorrichtung fließen, woraus allein anhand des Stromflusses in dem mindestens einen Kabel, in dem Wandler oder auch an dem Versorgungsanschluss oder an dem Abgabeanschluss geschlossen wird, dass kein Kontakt zwischen Abgabeanschluss und Ladeanschluss besteht. Ein Stromfluss von im Wesentlichen Null führt daher zur Aufhebung der Fahrblockierung, wohingegen ein Stromfluss von größer als Null als Verbindung zwischen Abgabeanschluss und Ladeanschluss gewertet wird und somit der Fahrbetrieb blockiert wird, vorzugsweise mittels Steuerbefehlen über die Datenschnittstellen des Abgabeanschlusses und des Ladeanschlusses. Anstatt einer aktiven Übermittlung von Steuerdaten durch die elektrische Verbindungsvorrichtung kann die elektrische Verbindungsvorrichtung auch gemäß einem Polling-Verfahren Steuerdaten/Sensordaten auf Abruf durch eine Fahrzeugsteuerung abgeben.

### Kurze Beschreibung der Zeichnungen

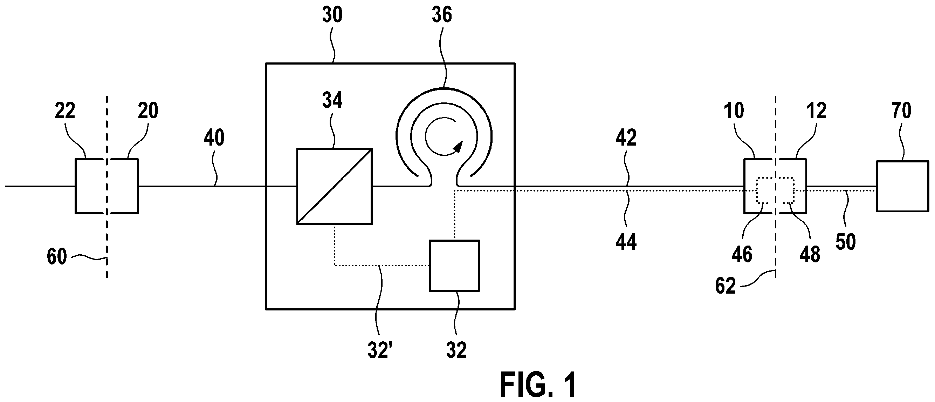

- Die Figur 1 zeigt: eine Ausführung der erfindungsgemäßen elektrischen Verbindungsvorrichtung in Prinzipdarstellung.

### Detaillierte Beschreibung der Zeichnung

Die Figur 1 zeigt in schematischer Darstellung eine Ausführungsform der erfindungsgemäßen elektrischen Verbindungsvorrichtung mit einem Abgabeanschluss 10 und einem Versorgungsanschluss 20. Die elektrische Verbindungsvorrichtung umfasst ferner einen Wechselstrom/Gleichstromwandler 30, der mit einer Wandlersteuerung 32 und einem Leistungsumsetzer 34 zur Umwandlung von Wechselstrom in Gleichstrom ausgestattet ist. Der Wandler 30 umfasst daher nicht nur die Stromwandlerkomponente 34 in Form des Umsetzers selbst, sondern auch die Wandlersteuerung 32. Der Wandler 30 der erfindungsgemäßen Verbindungsvorrichtung umfasst ferner eine Kabeltrommel 36, um zumindest einen Kabelabschnitt aufnehmen zu können. In Figur 1 ist der Wandler lediglich symbolisch dargestellt, wobei die Funktionen des Steuerns, des Wandelns und des Speicherns von Kabelabschnitten symbolisch mit den Bezugszeichen 32, 34 und 36 dargestellt sind, und der Wandler 30 diese Funktionen vereinigt in Form des Rechtecks, das die Abbildungen 32, 34 und 36 der Funktionen des Wandlers 30 umschreibt. In der realen Umsetzung ist hingegen der Wandler körperlich im Wesentlichen durch die Kabeltrommel definiert, in der Kabel, Steuerung 32 und Umsetzer 34 untergebracht sind.

Erfindungsgemäß ist der Abgabeanschluss 10 eingerichtet, mit einem Ladeanschluss 12 eines Fahrzeugs (nicht dargestellt) verbunden zu werden. Abgabeanschluss 10 und Ladeanschluss 12 sind somit komplementäre Steckverbindungselemente.

In gleicher Weise ist der Versorgungsanschluss 20 vorgesehen, mit einem Netzanschluss 22 verbunden zu werden, so dass Versorgungsanschluss 20 komplementär zu dem Netzanschluss 22 ausgebildet ist. Der Netzanschluss 22 ist an ein Wechselstrom-Niederspannungsverbundnetz angeschlossen (nicht dargestellt). Die erfindungsgemäße elektrische Verbindungsvorrichtung nach Figur 1 umfasst ferner zwei Kabel 40, 42, wobei das Kabel 40 bzw. der Kabelabschnitt 40 zwischen dem Wechselstrom/Gleichstromwandler 30 und dem Versorgungsanschluss 20 vorgesehen ist, um diese miteinander zu verbinden. In gleicher Weise ist Kabel 42 bzw. Kabelabschnitt 42 zwischen dem Wandler 30 und dem Abgabeanschluss 10 vorgesehen, und sieht eine elektrische Verbindung zwischen diesen Komponenten vor. Die von den Kabeln vorgesehene elektrische Verbindung zur Übertragung von Ladeenergie vom Netzanschluss 22 an den Ladeanschluss 12 ist mit durchgezogener Linie dargestellt.

Darüber hinaus umfasst die erfindungsgemäße Verbindungsvorrichtung Steuer- bzw. Datenverbindungen, die gepunktet dargestellt sind. Zum einen ist über eine derartige Steuerverbindung die Wandlersteuerung 32 mit dem Umsetzer 34 verbunden, um diesen gemäß Sollwertvorgaben anzusteuern. Ferner sieht das Kabel 42 neben einer Verbindung zur Übertragung von elektrischer Ladeenergie auch eine Datenverbindung vor, die gepunktet dargestellt ist. Diese Datenverbindung 44 erstreckt sich zwischen dem Wandler 30 und dem Abgabeanschluss 10. Der Abgabeanschluss 10 umfasst ferner Vorrichtungen zur Datenübertragung 46, die eine Datenschnittstelle für den Abgabeanschluss 10 bilden. Die Kontakte, welche diese Schnittstelle 46 realisieren, sind vorzugsweise fest mit den Kontakten verbunden, die den leistungsübertragenden Teil des Abgabeanschluss 10 vorsehen. Die Datenschnittstelle 46 des Abgabeanschlusses ist komplementär ausgebildet zu der Datenschnittstelle 48, die dem Ladeanschluss zugehört. Dadurch wird eine Datenverbindung vorgesehen zwischen der Datenschnittstelle 48 des Ladeanschlusses 12, der dazu komplementären Datenschnittstelle 46 des Abgabeanschlusses 10 und der Datenverbindung 44, die zwischen dem Wandler und dem Abgabeanschluss verläuft. Gemäß einer ersten Ausführungsform wird die Datenverbindung 44 als ein physikalischer Kanal ausgeführt, der getrennt von dem Kabel 42 ist. Alternativ kann die Datenverbindung 44 logisch getrennt von der Leistungsverbindung 42 sein, jedoch physikalisch durch die gleiche Entität ausgebildet sein. In diesem Fall ist beispielsweise das Kabel 42 zur Übertragung von Ladeleistung vorgesehen, und die Datenverbindung 44 ist durch ein auf das Kabel aufmoduliertes Signal vorgesehen, das am Abgabeanschluss 10 logisch (beispielsweise durch Filterung) von der Leistungsübertragung 42 getrennt wird. In diesem Fall sieht die Steuerung 42 eine derartige Modulation und/oder Filterung zum Senden bzw. Empfangen vor. Ferner kann die Datenverbindung 44 in der anderen Richtung aufgebaut sein, wobei in diesem Fall die Schnittstelle 48 des Ladeanschlusses (oder eine Steuerung des Fahrzeugs) ein Signal auf das bestehende Kabel und den Abgabeanschluss 10 aufmoduliert, um das aufmodulierte Signal durch die Steuerung 32 logisch von der Kabelverbindung 42 abzutrennen.

Unabhängig von der tatsächlichen Realisierung zeigt die Ausführung von Figur 1 eine Kabelverbindung 44, über die beispielsweise Steuerdaten von dem Fahrzeug (nicht dargestellt) über die Datenschnittstellen des Ladeanschlusses und des Abgabeanschlusses 46, 48 über die Datenverbindung 44 an den Wandler 30 übertragen werden. Die Steuerung erfasst die Signale und steuert demgemäß über die Steuerverbindung 32' den Umsetzer 34 an. In der gleichen Übertragungsrichtung kann durch die Schnittstellen 46, 48 ein Sensor vorgesehen sein, mit dem sich erfassen lässt, ob der Abgabeanschluss in dem Ladeanschluss steckt oder nicht. Dazu kann ein zusätzlicher Sensor (nicht dargestellt) innerhalb des Abgabeanschlusses 10 oder an diesem vorgesehen sein, der den Steckzustand erfasst. Das dem Stecksignal entsprechende Sensorsignal wird von der Datenleitung 44 an den Wandler 30 übermittelt, dessen Steuerung 32 dieses Signal erfasst und daraus ableitet, ob Abgabeanschluss 10 noch mit Ladeanschluss 12 verbunden ist oder nicht. (Alternativ kann der Stromfluss durch das Kabel 42 erfasst werden, beispielsweise durch Umsetzer 34 oder durch die Steuerung 32, um aus dem Stromfluss darauf zu schließen, ob der Abgabeanschluss 10 noch mit dem Ladeanschluss 12 verbunden ist. Wenn (unabhängig von der Erfassungsmethode) erfasst wird, dass der Abgabeanschluss 10 mit dem Ladeanschluss 12 verbunden ist (oder deren Datenschnittstellen 46, 48 miteinander verbunden sind), dann erzeugt die Steuerung 32 des Wandlers 30 ein Steuersignal, das über die Datenverbindung 44 von dem Wandler 30 an die Datenschnittstelle 46 des Abgabeanschlusses 10 übermittelt wird, von dieser an die Datenschnittstelle 48 des Ladeanschlusses und ausgehend von dieser Datenschnittstelle 48 weiter an eine Steuerung (nicht dargestellt) über eine fahrzeuginterne Datenleitung 50. Über diesen Pfad übermittelt der erfindungsgemäße Wandler 30 einen Sperrbefehl, der das Fahrzeug (nicht dargestellt) daran hindert, in einen Fahrzustand überzugehen.

Wie bereits bemerkt, ist die erfindungsgemäße Verbindungsvorrichtung weder Bestandteil eines Fahrzeugs noch Teil des Netzanschlusses oder des Wechselstrom-Niederspannungsverbundnetzes. Vielmehr sieht der Abgabeanschluss 10 und der Versorgungsanschluss 20 jeweils ein Verbindungselement vor, das komplementär zu dem Netzanschluss bzw. zu dem Ladeanschluss ist. Die entsprechenden Schnittstellen sind durch die gestrichelten Linien 60, 62 dargestellt, wobei die Schnittstelle 60 der Energieübertragung zwischen Netzanschluss 22 und Versorgungsanschluss 20 dient, jedoch die Verbindungsvorrichtung von dem Netzanschluss und dem Verbundnetz trennt, um die Schnittstelle 32 der Leistungsübertragung (und auch der Datenübertragung) zwischen dem Abgabeanschluss 10 und dem Ladeanschluss 12 (bzw. deren Schnittstellen 46, 48) dient. Sowohl Schnittstelle 60 als auch Schnittstelle 62 sind durch trennbare elektrische Verbindungen vorgesehen, so dass die elektrische Verbindungsvorrichtung grundsätzlich trennbar von dem Fahrzeug und trennbar von dem Netzanschluss vorgesehen ist.

## Patentansprüche

1. Elektrische Verbindungsvorrichtung mit:
einem Abgabeanschluss (10), der eingerichtet ist, mit einem Ladeanschluss (12) einer Akkumulatorvorrichtung (70) eines mit Strom betriebenen Fahrzeugs abtrennbarverbunden zu werden,
wobei die elektrische Verbindungsvorrichtung ferner einen Versorgungsanschluss (20) aufweist, der eingerichtet ist, mit einem Netzanschluss (22) eines Wechselstrom-Niederspannungsverbundnetzes abtrennbar verbunden zu werden,
wobei die elektrische Verbindungsvorrichtung einen Wechselstrom/Gleichstromwandler (30) umfasst, der eingerichtet ist, die Wechselspannung des Versorgungsanschlusses (20) in eine für die Akkumulatorvorrichtung (70) geeignete elektrische Gleichspannung einstellbarer Höhe umzuwandeln,
wobei die elektrische Verbindungsvorrichtung kein Bestandteil des Fahrzeuges ist,
wobei der Wechselstrom/Gleichstromwandler (30) eingerichtet ist, an ein 110 V-Netz und an ein 230 V-Netz mit einer Wechselspannung einer Frequenz von 50 Hz oder 60 Hz angeschlossen zu werden und daraus die Gleichspannung einstellbarer Höhe zu erzeugen, die am Abgabeanschluss (10) abgebbar ist, **dadurch gekennzeichnet, dass** die elektrische Verbindungsvorrichtung mindestens ein Kabel (40, 42) sowie eine Kabeltrommel (36) aufweist, die zur im Wesentlichen vollständigen Aufnahme des Kabels (40,42) eingerichtet ist, wobei der Wechselstrom/Gleichstromwandler (30) vollständig in der Kabeltrommel (36) aufgenommen ist, und das mindestens eine Kabel (40,42) den Abgabeanschluss (10) über den Wechselstrom/Gleichstromwandler (30) mit dem Versorgungsanschluss (20) verbindet, und dass
der Abgabeanschluss (10) ferner eine Datenschnittstelle (46) aufweist, die zum Anschluss (10) an eine Datenschnittstelle (48) eines an den Abgabeanschluss (10) anschließbaren Ladeanschlusses (12) eingerichtet ist, wobei die elektrische Verbindungseinrichtung eingerichtet ist, über die Datenschnittstelle (46) des Abgabeanschlusses (10) Sensordaten oder Steuerdaten an die Datenschnittstelle (48) des Ladeanschlusses (12) abzugeben, wobei die Sensordaten einen Steckzustand des Abgabeanschlusses (10) oder andere Zustandsdaten der elektrischen Verbindungseinrichtung wiedergeben, und die Steuerdaten einen Fahrbetrieb-Sperrbefehl wiedergeben, und wobei die elektrische Verbindungseinrichtung eingerichtet ist, über die Datenschnittstelle (46) des Abgabeanschlusses (10) Sensordaten oder Steuerdaten von der Datenschnittstelle (48) des Ladeanschlusses (12) zu empfangen, wobei nach dem Fahrbetrieb-Sperrbefehl ein Fahrbetrieb sperrbar ist, wenn ermittelt ist, dass sich das Kabel (40,42) der elektrischen Verbindungsvorrichtung nicht im vollständig aufgerollten Zustand in der Kabeltrommel (36) befindet.

2. Elektrische Verbindungsvorrichtung nach Anspruch 1, wobei der Abgabeanschluss (10) eingerichtet ist, mit dem Ladeanschluss (12) der Akkumulatorvorrichtung (70) eines Hybrid- oder Elektro-Personenkraftfahrzeugs verbunden zu werden.

3. Elektrische Verbindungsvorrichtung nach Anspruch 1 oder 2, wobei der Wechselstrom/Gleichstromwandler (30) einen Speicher umfasst, in dem ein Wert abgelegt ist, der die Höhe der Gleichspannung als Sollwert definiert, und einen Eingang umfasst, an den die Höhe der Gleichspannung als Sollwert für den Wechselstrom/Gleichstromwandler (30) eingeben werden kann, oder einen Schalter umfasst, dessen Stellung die Höhe der Gleichspannung als Sollwert definiert, oder ein Potentiometer umfasst, dessen Stellung die Höhe der Gleichspannung als Sollwert definiert.

4. Elektrische Verbindungseinrichtung nach einem der vorangehenden Ansprüche, die ferner einen Sensor umfasst, der in dem Abgabeanschluss (10) oder an dem Wechselstrom/Gleichstromwandler (30) vorgesehen ist, und der eingerichtet ist, elektronisch oder mechanisch zu ermitteln, ob der Abgabeanschluss (10) in einem daran anschließbaren Ladeanschluss (12) eingesteckt ist, oder zu ermitteln, ob sich ein Kabel (42) der elektrischen Verbindungseinrichtung im vollständig eingerollten Zustand befindet.

5. Elektrische Verbindungseinrichtung nach einem der vorangehenden Ansprüche, wobei die Steuerdaten einen Aufladebeginnbefehl, einen Erhaltungsladungsbefehl oder andere Lade- oder Fahrbetriebsdaten wiedergeben, wobei die Sensordaten einen Ladezustand der Akkumulatorvorrichtung (70) oder andere Betriebszustandsdaten des Fahrzeugs oder der Akkumulatorvorrichtung (70) wiedergeben, und die Steuerdaten eine Soll-Ladespannung, ein Soll-Ladeverhalten oder andere Ladeparameter wiedergeben, die zur Umsetzung durch den Wechselstrom/Gleichstromwandler (30) vorgesehen sind.

6. Verfahren zum Aufladen einer Akkumulatorvorrichtung (70) eines mit Strom betriebenen Fahrzeugs mittels einer elektrischen Verbindungsvorrichtung, nach einem der Ansprüche 1 bis 5, umfassend: Wandeln einer Wechselspannung eines Wechselstrom-Niederspannungsverbundnetzes in eine Gleichspannung einstellbarer Höhe, die zum Aufladen oder Erhaltungsladen einer Akkumulatorvorrichtung (70) geeignet ist, mittels eines Wechselst rom/ Gleichst romwandlers (30), und Zuführen der Gleichspannung über einen Abgabeanschluss (10) der elektrischen Verbindungsvorrichtung an einen Ladeanschluss (12) des Fahrzeugs, wobei die elektrische Verbindungsvorrichtung den Wechselstrom/Gleichstromwandler (30) umfasst und die elektrische Verbindungsvorrichtung einschließlich des Wechselstrom/Gleichstromwandlers (30) während des Ladens außerhalb des Fahrzeugs vorgesehen ist und während des Ladens der Abgabeanschluss (10) abtrennbar mit dem Ladeanschluss (12) verbunden ist, wobei die elektrische Verbindungsvorrichtung kein Bestandteil des Fahrzeuges ist, und wobei der Wechselstrom/Gleichstromwandler (30) eingerichtet ist, an ein 110 V-Netz und an ein 230 V-Netz mit einer Wechselspannung einer Frequenzvon 50 Hz oder 60 Hz angeschlossen zu werden und daraus die Gleichspannung einstellbarer Höhe zu erzeugen, die am Abgabeanschluss (10) abgegeben wird, **dadurch gekennzeichnet, dass**
weiterhin ein Erfassen eines Steckzustands oder eines Ausrollzustandes der elektrischen Verbindungsvorrichtung erfolgt; und ein Sperren des Fahrbetriebs des Fahrzeugs erfolgt, wenn durch den Schritt des Erfassens ermittelt wird, dass sich das Kabel (40, 42) der elektrischen Verbindungsvorrichtung nicht im vollständig aufgerollten Zustand befindet.

7. Verfahren nach Anspruch 6, wobei der Schritt des Erfassens von der elektrischen Verbindungseinrichtung ausgeführt wird und Sperren umfasst: Erzeugen und Übermitteln eines Sperrbefehls mittels der elektrischen Verbindungseinrichtung an das Fahrzeug oder an eine Fahrsteuerung des Fahrzeugs.

8. Verfahren nach Anspruch 6 oder 7, wobei der Sperrbefehl übermittelt wird über eine Datenschnittstelle (46), die von der elektrischen Verbindungseinrichtung vorgesehen wird, und die beim Entfernen bzw. beim Einstecken des Abgabeanschlusses (10) durch eine mechanische Verbindung zwischen der Datenschnittstelle (46) der elektrischen Verbindungseinrichtung und dem Abgabeanschluss (10) von einer Datenschnittstelle (48) des Ladeanschlusses (12) getrennt bzw. mit dieser verbunden wird.

## Claims

1. Electrical connecting apparatus comprising:
an output connection (10) which is designed to be connected in a detachable manner to a charging connection (12) of a rechargeable battery apparatus (70) of an electrically operated vehicle,
wherein the electrical connecting apparatus further has a supply connection (20) which is designed to be connected in a detachable manner to a supply system connection (22) of an alternating-current low-voltage integrated supply system,
wherein the electrical connecting apparatus comprises an alternating current/direct current converter (30) which is designed to convert the AC voltage of the supply connection (20) into an electrical DC voltage which is suitable for the rechargeable battery apparatus (70),
wherein the electrical connecting apparatus is not a constituent part of the vehicle,
wherein the alternating current/direct current converter (30) is designed to be connected to a 110 V supply system and to a 230 V supply system with an AC voltage with a frequency of 50 Hz or 60 Hz and to generate from this the adjustable-level DC voltage which can be output at the output connection (10), **characterized in that** the electrical connecting apparatus has at least one cable (40, 42) and also a cable drum (36) which is designed for substantially completely receiving the cable (40, 42), wherein the alternating current/direct current converter (30) is fully received in the cable drum (36), and the at least one cable (40, 42) connects the output connection (10), via the alternating current/direct current converter (30), to the supply connection (20), and **in that**
the output connection (10) further has a data interface (46) which is designed for connection (10) to a data interface (48) of a charging connection (12) which can be connected to the output connection (10), wherein the electrical connecting device is designed to output sensor data or control data to the data interface (48) of the charging connection (12) via the data interface (46) of the output connection (10), wherein the sensor data represent a plug-in state of the output connection (10) or other state data of the electrical connecting device, and the control data represent a driving mode blocking command, and wherein the electrical connecting device is designed to receive sensor data or control data from the data interface (48) of the charging connection (12) via the data interface (46) of the output connection (10), wherein, after the driving mode blocking command, a driving mode can be blocked when it is determined that the cable (40, 42) of the electrical connecting apparatus is not in the fully rolled-up state in the cable drum (36) .

2. Electrical connecting apparatus according to Claim 1, wherein the output connection (10) is designed to be connected to the charging connection (12) of the rechargeable battery apparatus (70) of a hybrid or electric passenger car.

3. Electrical connecting apparatus according to Claim 1 or 2, wherein the alternating current/direct current converter (30) comprises a memory in which a value is stored, which value defines the level of the DC voltage as a setpoint value, and comprises an input at which the level of the DC voltage can be input as a setpoint value for the alternating current/direct current converter (30), or comprises a switch, the position of which defines the level of the DC voltage as a setpoint value, or comprises a potentiometer, the position of which defines the level of the DC voltage as a setpoint value.

4. Electrical connecting device according to one of the preceding claims, which further comprises a sensor which is provided in the output connection (10) or on the alternating current/direct current converter (30), and which is designed to electronically or mechanically determine whether the output connection (10) is inserted into a charging connection (12) which can be connected to it, or to determine whether a cable (42) of the electrical connecting device is in the fully rolled-in state.

5. Electrical connecting device according to one of the preceding claims, wherein the control data represent a charging start command, a maintenance charging command or other charging or driving mode data, wherein the sensor data represent a state of charge of the rechargeable battery apparatus (70) or other operating state data of the vehicle or of the rechargeable battery apparatus (70), and the control data represent a setpoint charging voltage, a setpoint charging behaviour or other charging parameters which are provided for implementation by the alternating current/direct current converter (30).

6. Method for charging a rechargeable battery apparatus (70) of an electrically operated vehicle by means of an electrical connecting apparatus according to one of Claims 1 to 5, comprising: converting an AC voltage of an alternating-current low-voltage integrated supply system into an adjustable-level DC voltage, which is suitable for charging or maintenance charging a rechargeable battery apparatus (70), by means of an alternating current/direct current converter (30), and supplying the DC voltage via an output connection (10) of the electrical connecting apparatus to a charging connection (12) of the vehicle, wherein the electrical connecting apparatus comprises the alternating current/direct current converter (30) and the electrical connecting apparatus including the alternating current/direct current converter (30) is provided outside the vehicle during charging and the output connection (10) is connected in a detachable manner to the charging connection (12) during charging, wherein the electrical connecting apparatus is not a constituent part of the vehicle, and wherein the alternating current/direct current converter (30) is designed to be connected to a 110 V supply system and to a 230 V supply system with an AC voltage with a frequency of 50 Hz or 60 Hz and to generate from this the adjustable-level DC voltage which is output at the output connection (10), **characterized in that**
furthermore detection of a plug-in state or a rolled-up state of the electrical connection apparatus takes place; and blocking of the driving mode of the vehicle takes place when it is determined by the detection step that the cable (40, 42) of the electrical connecting apparatus is not in the fully rolled-up state.

7. Method according to Claim 6, wherein the detection step is executed by the electrical connecting device and blocking comprises: generating and transmitting a blocking command by means of the electrical connecting device to the vehicle or to a driving controller of the vehicle.

8. Method according to Claim 6 or 7, wherein the blocking command is transmitted via a data interface (46) which is provided by the electrical connecting device, and which, when the output connection (10) is removed or plugged in, is separated from a data interface (48) of the charging connection (12) or connected to the said data interface by a mechanical connection between the data interface (46) of the electrical connecting device and the output connection (10).

## Revendications

1. Dispositif de connexion électrique, comprenant :
une borne de sortie (10) qui est aménagée pour être reliée de manière détachable à une borne de charge (12) d'un dispositif accumulateur (70) d'un véhicule électrique,
le dispositif de connexion électrique présentant en outre une borne d'alimentation (20) qui est aménagée pour être reliée de manière détachable à une borne de réseau (22) d'un réseau d'interconnexion basse tension à courant alternatif,
le dispositif de connexion électrique comprenant un convertisseur courant alternatif/courant continu (30) qui est aménagé pour convertir la tension alternative de la borne d'alimentation (20) en une tension continue électrique d'un niveau réglable, adaptée au dispositif accumulateur (70),
dans lequel le dispositif de connexion électrique ne fait pas partie du véhicule,
le convertisseur courant alternatif/courant continu (30) étant aménagé pour être connecté à un réseau 110 V et à un réseau 230 V avec une tension alternative d'une fréquence de 50 Hz ou 60 Hz et pour en produire la tension continue de niveau réglable qui peut être sortie à la borne de sortie (10),
**caractérisé en ce que** le dispositif de connexion électrique présente au moins un câble (40, 42) ainsi qu'un enrouleur de câble (36) qui est aménagé pour la réception substantiellement entière du câble (40, 42), le convertisseur courant alternatif/courant continu (30) étant reçu entièrement dans l'enrouleur de câble (36), et ledit au moins un câble (40, 42) relie la borne de sortie (10) à la borne d'alimentation (20) par l'intermédiaire du convertisseur courant alternatif/courant continu (30), et **en ce que**
la borne de sortie (10) présente en outre une interface de données (46) qui est aménagée pour une connexion (10) à une interface de données (48) d'une borne de charge (12) pouvant être connectée à la borne de sortie (10), l'équipement de connexion électrique étant aménagé pour sortir des données de capteur ou des données de commande à l'interface de données (48) de la borne de charge (12) par l'intermédiaire de l'interface de données (46) de la borne de sortie (10), les données de capteur représentant un état d'enfichage de la borne de sortie (10) ou d'autres données d'état de l'équipement de connexion électrique, et les données de commande représentant une instruction de blocage de mode de conduite, et l'équipement de connexion électrique étant aménagé pour recevoir par l'intermédiaire de l'interface de données (46) de la borne de sortie (10) des données de capteur ou des données de commande de l'interface de données (48) de la borne de charge (12), dans lequel, après l'instruction de blocage de mode de conduite, un mode de conduite peut être bloqué s'il est déterminé que le câble (40, 42) du dispositif de connexion électrique ne se trouve pas à l'état entièrement enroulé dans l'enrouleur de câble (36).

2. Dispositif de connexion électrique selon la revendication 1, dans lequel la borne de sortie (10) est aménagée pour être reliée à la borne de charge (12) du dispositif accumulateur (70) d'une voiture particulière hybride ou électrique.

3. Dispositif de connexion électrique selon la revendication 1 ou 2, dans lequel le convertisseur courant alternatif/courant continu (30) comprend une mémoire dans laquelle est stockée une valeur qui définit le niveau de la tension continue sous forme de valeur de consigne, et comprend une entrée à laquelle le niveau de la tension continue peut être entré sous forme de valeur de consigne pour le convertisseur courant alternatif/courant continu (30), ou comprend un commutateur dont la position définit le niveau de la tension continue sous forme de valeur de consigne, ou comprend un potentiomètre dont la position définit le niveau de la tension continue sous forme de valeur de consigne.

4. Equipement de connexion électrique selon l'une quelconque des revendications précédentes, comprenant en outre un capteur qui est prévu dans la borne de sortie (10) ou sur le convertisseur courant alternatif/courant continu (30) et qui est aménagé pour déterminer de manière électronique ou mécanique si la borne de sortie (10) est enfichée dans une borne de charge (12) pouvant être connectée à celle-ci, ou pour déterminer si un câble (42) de l'équipement de connexion électrique se trouve à l'état entièrement enroulé.

5. Equipement de connexion électrique selon l'une quelconque des revendications précédentes, dans lequel les données de commande représentent une instruction de début de recharge, une instruction de charge de maintien ou d'autres données de mode de charge ou de conduite, les données de capteur représentant un état de charge du dispositif accumulateur (70) ou d'autres données d'état de fonctionnement du véhicule ou du dispositif accumulateur (70), et les données de commande représentant une tension de charge de consigne, un comportement de charge de consigne ou d'autres paramètres de charge qui sont prévus pour être mis en œuvre par le convertisseur courant alternatif/courant continu (30).

6. Procédé permettant de recharger un dispositif accumulateur (70) d'un véhicule électrique au moyen d'un dispositif de connexion électrique selon l'une quelconque des revendications 1 à 5, comprenant les étapes consistant à : convertir une tension alternative d'un réseau d'interconnexion basse tension à courant alternatif en une tension continue de niveau réglable qui est adaptée pour recharger ou maintenir la charge d'un dispositif accumulateur (70) au moyen d'un convertisseur courant alternatif/courant continu (30), et amener la tension continue du dispositif de connexion électrique à une borne de charge (12) du véhicule, par l'intermédiaire d'une borne de sortie (10), le dispositif de connexion électrique comprenant le convertisseur courant alternatif/courant continu (30), et le dispositif de connexion électrique avec le convertisseur courant alternatif/courant continu (30) étant prévu à l'extérieur du véhicule pendant le chargement, et la borne de sortie (10) étant reliée de manière détachable à la borne de charge (12) pendant le chargement, dans lequel le dispositif de connexion électrique ne fait pas partie du véhicule, et dans lequel le convertisseur courant alternatif/courant continu (30) est aménagé pour être connecté à un réseau 110 V et à un réseau 230 V avec une tension alternative d'une fréquence de 50 Hz ou 60 Hz et pour en produire la tension continue de niveau réglable qui est sortie à la borne de sortie (10),
**caractérisé en ce qu'**en outre, une détection d'un état d'enfichage ou d'un état déroulé du dispositif de connexion électrique est effectuée ; et un blocage du mode de conduite du véhicule est effectué si l'étape de détection détermine que le câble (40, 42) du dispositif de connexion électrique ne se trouve pas à l'état entièrement enroulé.

7. Procédé selon la revendication 6, dans lequel l'étape de la détection de l'équipement de connexion électrique est effectuée et le blocage comprend : la génération et la transmission d'une instruction de blocage au moyen de l'équipement de connexion électrique au véhicule ou à une commande de conduite du véhicule.

8. Procédé selon la revendication 6 ou 7, dans lequel l'instruction de blocage est transmise par l'intermédiaire d'une interface de données (46) qui est prévue par l'équipement de connexion électrique, et qui, lors du retrait ou de l'enfichage de la borne de sortie (10), est séparée de ou reliée à celui-ci par un dispositif mécanique entre l'interface de données (46) de l'équipement de connexion électrique et la borne de sortie (10) d'une interface de données (48) de la borne de charge (12).
